# FASCICULE DE BREVET EUROPEEN

(11) **EP 2 406 815 B1**
(45) Date de publication et mention de la délivrance du brevet: **18.07.2018**
(21) Numéro de dépôt: 10708971.6
(22) Date de dépôt: 09.03.2010
(51) Int. Cl.: H01L 21/56, H01L 23/00, B81C 1/00, H01L 23/433, H01L 21/683, H01L 25/065, H01L 25/10, H01L 25/00

(54) **PROCEDE DE POSITIONNEMENT DES PUCES LORS DE LA FABRICATION D'UNE PLAQUE RECONSTITUEE**
VERFAHREN ZUM POSITIONIEREN VON CHIPS WÄHREND DER HERSTELLUNG EINER REKONSTITUIERTEN LEITERPLATTE
METHOD FOR POSITIONING CHIPS DURING THE PRODUCTION OF A RECONSTITUTED BOARD

(30) Priorité: 10.03.2009 FR 0901095
(43) Date de publication de la demande: 18.01.2012
(73) Titulaire: 3D Plus, 78532 Buc Cedex (FR)
(72) Inventeur: VAL, Christian, F-78470 St Remy Les Chevreuse (FR)
(74) Mandataire: Henriot, Marie-Pierre
(86) Numéro de dépôt international: PCT/EP2010/052964
(87) Numéro de publication internationale: WO 2010/102996

(56) Documents cités:
- WO-A-02/15266
- DE-A1- 10 250 621
- US-B1- 6 271 469
- US-B1- 6 608 391

## Description

Le domaine de l'invention est celui de la fabrication de plaques (ou « wafers » en anglais) reconstituées qui comprennent des puces encapsulées dans une résine, ces puces ayant en général été préalablement testées.

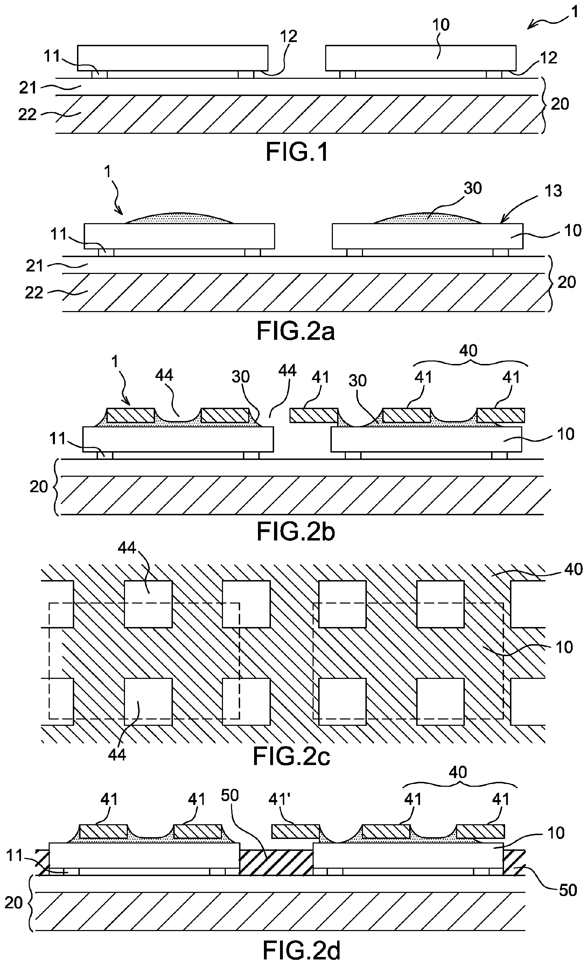

La solution la plus couramment mise en oeuvre pour réaliser une plaque reconstituée consiste à prélever différents types de puces ou « chips » généralement sélectionnées après avoir été testées et souvent désignées « Known Good Die ». On désigne par puce un composant électronique actif tel qu'une puce nue ou un composant passif ou un MEMS, acronyme de l'expression anglo-saxonne « Micro Electro Mechanical System ». Comme montré sur la figure 1, ces puces 10 qui présentent des plots de connexion 11 sur une face dite face active ou face avant 12, sont alors positionnées face avant sur un support adhésif 20 au moyen par exemple d'une machine « pick-and-place » ; ce support adhésif 20 est typiquement une peau collante 21 elle-même collée à un support rigide 22. Puis les puces sont encapsulées dans une résine polymère de type Epoxy afin de les solidariser. Une couche de redistribution ou RDL acronyme de l'expression anglo-saxonne « ReDistribution Layer » éventuellement à plusieurs étages, est ensuite formée du côté face avant, après retrait du support rigide 22 et de la peau collante 21 ; cette couche RDL qui comprend des pistes en TiW/Cu ou en TiPd/Au par exemple, est formée sur une couche diélectrique déposée à la place du support adhésif, par trempage ou par centrifugation. La plaque ainsi reconstituée qui ne comporte pas de puces défectueuses peut alors être découpée pour obtenir des micro boîtiers plastiques ; elle peut aussi être empilée sur d'autres plaques reconstituées, et électriquement connectée à ces plaques selon différents procédés connus, l'empilement étant ensuite découpé pour obtenir des modules électroniques à trois dimensions ou 3D.

L'encapsulation des puces comprend :
- une étape de dépôt de la résine (par coulage ou par moulage dit en compression), autour et éventuellement sur les puces collées sur le support adhésif, de manière à remplir les espaces inter-puces,
- une étape de polymérisation de la résine pour la durcir et ainsi former un substrat rigide et manipulable dans lequel sont fixées les puces, le substrat adhésif pouvant alors être retiré.

Un inconvénient notoire est le déplacement des puces lors du dépôt de la résine et/ou lors de sa polymérisation. En effet le retrait irréversible et la dilation réversible de la résine après polymérisation créent des micro déplacements des puces plus ou moins isotropes et prévisibles. Ces micro déplacements sont typiquement compris entre quelques µm et quelques dizaines de µm, ce qui peut excéder les tolérances de positionnement requises après moulage qui sont typiquement de l'ordre de 10 µm.

Une solution a été proposée qui consiste à disposer sur le support adhésif un treillis de cuivre à mailles rectangulaires puis à reporter les puces sur le support dans les cavités situées entre les barreaux entrecroisés du treillis ; ce treillis est ainsi utilisé comme gabarit dans lequel on place les puces. La résine est alors déposée entre les barreaux puis polymérisée. Ce procédé permet de réduire la dilatation et donc le déplacement des puces mais ne permet pas de l'éliminer. Il présente en outre les inconvénients suivants :
- le treillis reste obligatoirement dans le boîtier final puisqu'une fois moulé dans la résine, il ne peut plus être enlevé,
- cela limite le nombre de puces sur la plaque du fait de la place prise par le treillis,
- cela nécessite une double découpe pour faire disparaître les barreaux du treillis.

Le but de l'invention est de pallier cet inconvénient de déplacement des puces lors de leur moulage dans de la résine.

Plus précisément l'invention a pour objet un procédé de fabrication d'une plaque reconstituée qui comporte des puces présentant des plots de connexion sur une face de la puce dite face avant, ce procédé comprenant les étapes suivantes de :
- positionnement des puces sur un support adhésif, face avant sur le support,
- dépôt d'une résine sur le support pour encapsuler les puces,
- polymérisation de la résine.

Il est principalement caractérisé en ce qu'avant l'étape de dépôt de la résine, il comprend une étape de collage sur les puces d'une plaque de maintien du positionnement des puces, cette plaque comportant des parties disposées sur une face des puces.

Ce procédé permet de maintenir les puces à l'endroit où elles ont été positionnées, pendant et après leur moulage dans de la résine.

Le matériau des puces ayant un coefficient de dilatation d'environ 3 ppm/°C, le matériau de la plaque de maintien a avantageusement un coefficient de dilatation voisin de celui des puces, c'est-à-dire inférieur à 10 ppm/°C.

La plaque de maintien est en général totalement ou partiellement métallique.

La plaque de maintien est un treillis qui comporte des ouvertures.

Selon une caractéristique de l'invention, il comprend après l'étape de polymérisation, une étape de retrait total ou partiel de la plaque de maintien.

Cette plaque de maintien peut aussi contribuer à résoudre le problème thermique d'échauffement des puces en cours de fonctionnement. Ce problème est d'autant plus sensible dans les modules électroniques 3D dans lesquels des puces sont empilées.

A cet effet, selon une autre caractéristique de l'invention, des parties de la plaque de maintien, collés aux puces, sont en outre des éléments caloporteurs qui contribueront ainsi à évacuer la chaleur émise par les puces et aussi à uniformiser la chaleur de la puce pour éviter des points chauds qui nuisent à sa fiabilité.

Selon un premier mode d'exploitation, la plaque de maintien est un treillis collé sur les faces arrière des puces.

Dans ce cas, le collage du treillis sur les puces comprend par exemple une étape de dépôt de colle polymère sur les faces arrière des puces, une étape de positionnement du treillis de manière à positionner des éléments du treillis sur la colle puis une étape de polymérisation de la colle.

Le treillis peut comporter deux parties, une première partie formant un treillis, et des piliers formant une deuxième partie, ces piliers traversant la première partie.

Cette première partie du treillis peut être en céramique, par exemple en verre ou alumine ou nitrure d'aluminium.

Selon un exemple, la plaque de maintien est collée sur la face avant des puces.

Dans ce cas, le collage de la plaque de maintien aux puces comprend par exemple une étape de dépôt d'un film de colle sur la plaque de maintien, une étape de positionnement des puces sur ce film, de manière à coller les faces avant des puces à la plaque de maintien, une étape de polymérisation du film de colle et éventuellement il comprend une étape de retrait total ou partiel de la plaque de maintien après la polymérisation de la résine.

La colle est de préférence polymérisée à une température inférieure à 100 °C et/ou aux ultra violets et/ou aux micro-ondes.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement une plaque reconstituée en cours de fabrication, la plaque étant vue en coupe,

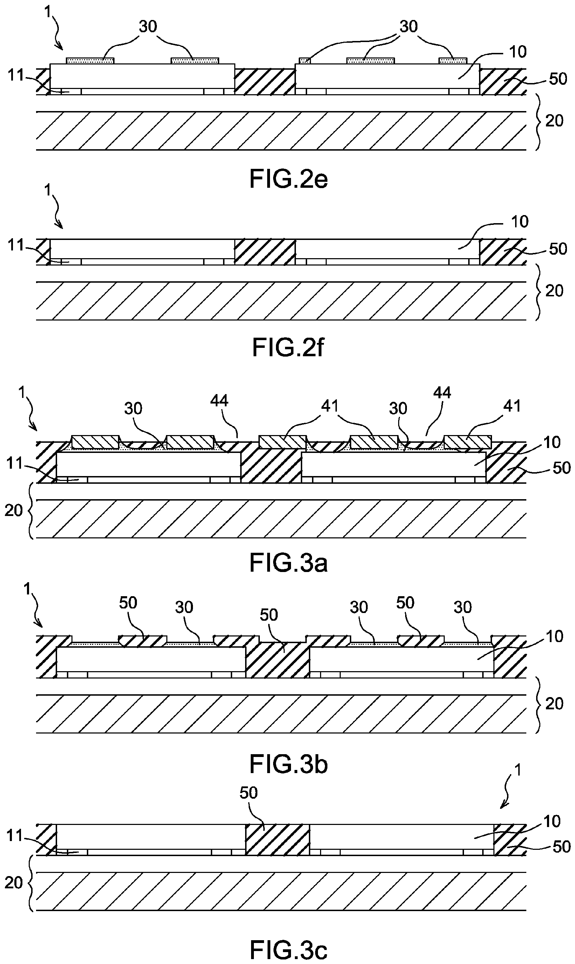

les figures 2 représentent schématiquement une plaque au cours de différentes étapes de fabrication selon l'invention, avec un treillis collé sur les faces arrière des puces, la résine ne dépassant pas le niveau des puces, la plaque étant vue en coupe sauf pour la figure 2c où il s'agit d'une vue de dessus,
les figures 3 représentent schématiquement une plaque au cours de différentes étapes de fabrication selon l'invention, avec un treillis collé sur les faces arrière des puces, la résine dépassant le niveau des puces sans noyer le treillis, la plaque étant vue en coupe,

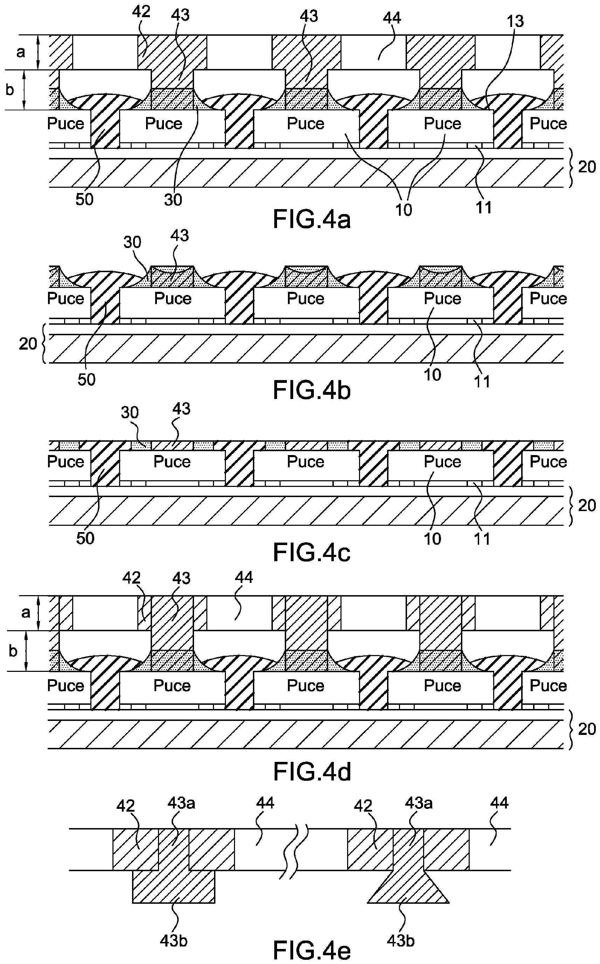

les figures 4a à 4d représentent schématiquement une plaque au cours de différentes étapes de fabrication selon l'invention, avec un treillis à piliers collé sur les faces arrière des puces, la résine pouvant encore plus dépasser le niveau des puces que dans le cas des figures 3, la plaque étant vue en coupe, la figure 4e présentant d'autres forme de piliers en coupe,

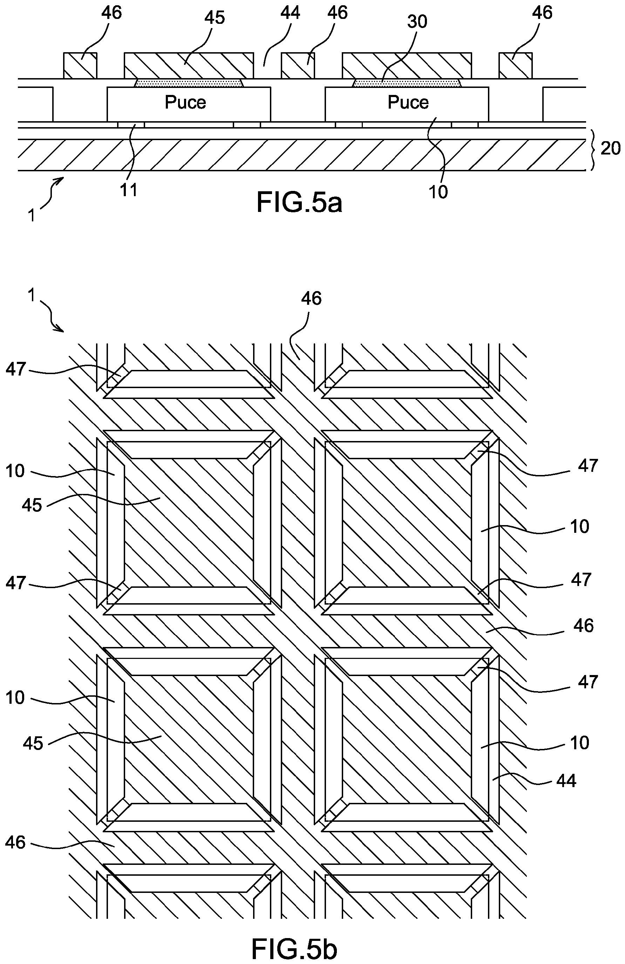

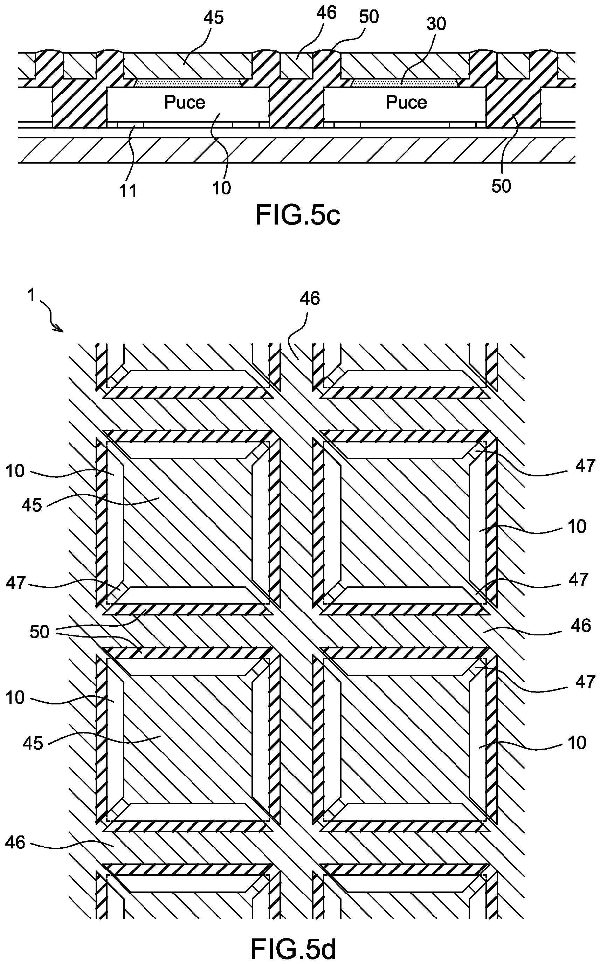

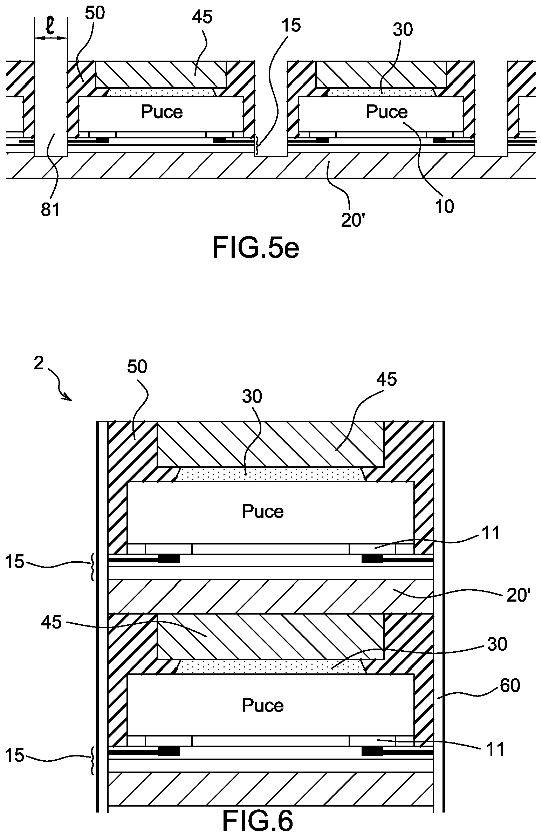

les figures 5 représentent schématiquement une plaque au cours de différentes étapes de fabrication selon l'invention, avec un treillis collé sur les faces arrière des puces, et dont une partie jouera le rôle d'éléments caloporteurs des puces, la plaque étant vue en coupe, sauf pour les figures 5b et 5d qui sont des vues de dessus,
la figure 6 représente schématiquement un exemple de module électronique 3D qui comprend un empilement de deux puces,

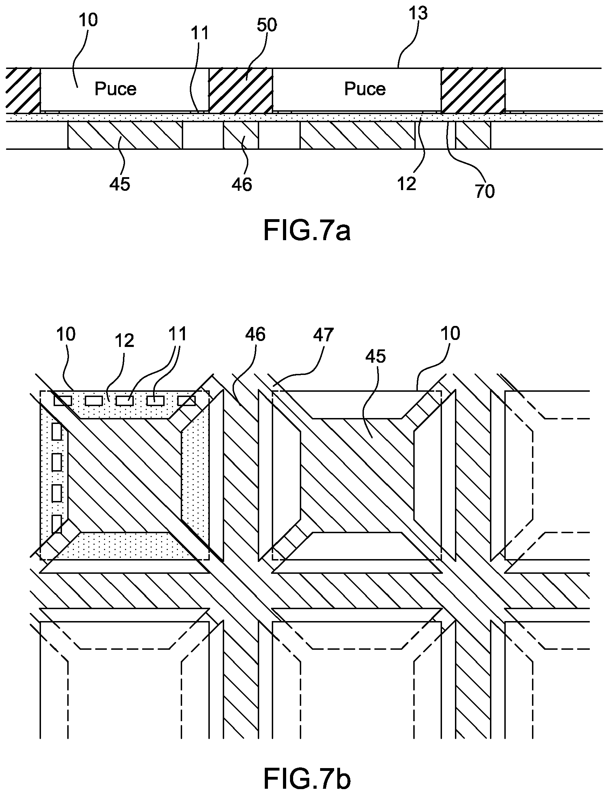

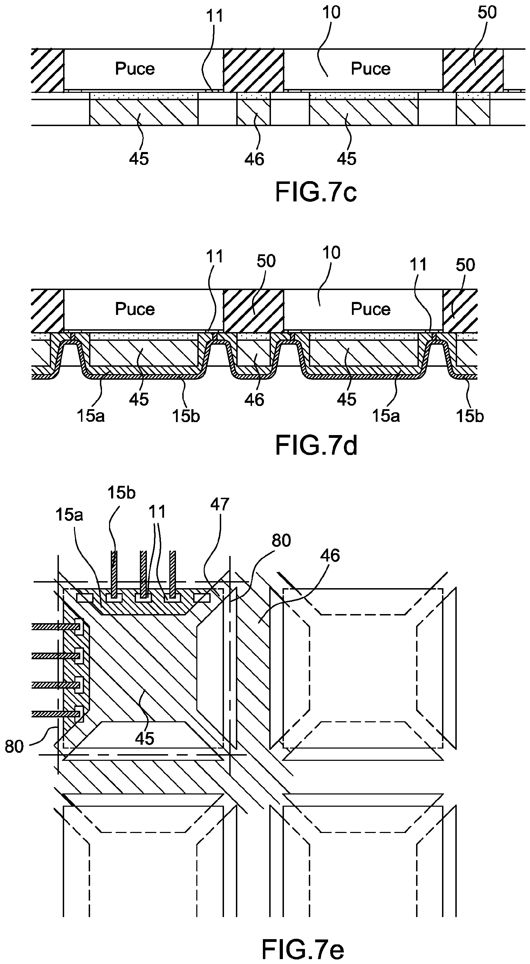

les figures 7 représentent schématiquement une plaque au cours de différentes étapes de fabrication selon l'invention, avec un treillis collé sur les faces avant des puces, et dont une partie jouera le rôle d'éléments caloporteurs des puces, la plaque étant vue en coupe, sauf pour les figures 7b et 7e qui sont des vues de dessus.

D'une figure à l'autre, les mêmes éléments sont repérés par les mêmes références. La référence 1 désigne la plaque reconstituée au cours des différentes étapes de sa fabrication.

Le procédé selon l'invention est basé sur l'utilisation d'une plaque de maintien. Contrairement au treillis de l'état de la technique, la plaque de maintien est collée sur les puces côté face arrière ou selon une variante côté face avant.

La plaque de maintien peut être en cuivre ou en aluminium, ces matériaux ayant un coefficient de dilatation compris entre 15 et 25 ppm/°C.

De préférence le matériau de la plaque de maintien a un coefficient de dilatation voisin de celui des puces (en fait du matériau principal des puces) de manière à se dilater quasiment de la même manière lors de la polymérisation de la résine, et ainsi préserver le positionnement antérieur à la polymérisation. Le silicium qui est typiquement le matériau des puces a un coefficient de dilatation d'environ 3 à 4 ppm/°C ; une plaque de maintien dont le matériau a un coefficient de dilatation inférieur à 10 ppm/°C tel que le ferro-nickel convient parfaitement. Une plaque de maintien en silicium peut également être envisagée.

La plaque de maintien généralement métallique est un treillis qui comporte des ouvertures 44.

Ce treillis est par exemple à mailles 44 rectangulaires comme on peut le voir figure 2c ; d'autres maillages sont envisageables qui seront décrits plus loin.

Les barreaux du treillis ou plus généralement ses différents éléments ont de préférence une section rectangulaire ou telle qu'au moins la face orientée vers les puces soit plane comme il apparaît sur les figures en coupe.

Le treillis métallique est par exemple obtenu par photogravure ou par estampillage ; il est réalisé avant d'être collé aux puces.

Selon un premier mode de réalisation décrit en relation avec les figures 2, le treillis 40 de maintien du positionnement des puces est collé sur les faces arrière 13 des puces, la face arrière étant bien sûr à l'opposé de la face avant. Cette étape intervient après le positionnement des puces 10 sur le support adhésif 20, et bien sûr avant le dépôt de la résine.

Cette étape comprend une première sous-étape de dépôt de colle polymère 30 sur la face arrière 13 des puces comme montré figure 2a ; il s'agit par exemple d'une colle de type Epoxy. Ce dépôt peut être réalisé par seringue ou par jet d'encre ou par sérigraphie ou par pochoir, ou par tout autre moyen connu de l'homme du métier. Le treillis 40 est déposé sur les puces lors d'une deuxième sous-étape montrée figures 2b et 2c, et enfin une troisième sous-étape de polymérisation de cette colle est réalisée à basse température c'est-à-dire à une température inférieure à 100°C, ou voisine de la température ambiante par exemple par polymérisation aux UV ou aux micro-ondes. La force d'adhérence de cette colle polymérisée est bien supérieure à celle de la peau collante que l'on peut grossièrement assimiler à du « Scotch ». Chaque puce 10 est ainsi collée à au moins un barreau 41 du treillis comme illustré en coupe figure 2c et vu de dessus figure 2d ; certains barreaux 41' peuvent éventuellement être partiellement ou totalement en dehors des puces 10 comme dans l'exemple de la figure 2d, cela dépendant du pas du maillage du treillis et de celui du positionnement des puces.

La résine 50 est alors déposée entre les puces 10 (figure 2d) sans atteindre le niveau du treillis 40, par un procédé de coulage classique tel que par seringue automatique, ce qui permet de couler au travers du treillis puisque celui-ci est ajouré par construction. Puis la résine est polymérisée de manière connue.

Le treillis métallique 40 est alors retiré par exemple par dissolution dans une solution classique de type perchlorure de fer. Restent sur les puces des points de colle visibles sur la figure 2e. Ceux-ci sont eux-mêmes retirés par exemple lors d'une opération d'amincissement des puces par attaque chimique ou par polissage : le résultat est montré figure 2f.

Selon une variante, la résine 50 est déposée jusqu'à atteindre le treillis 40 (ou les barreaux 41 du treillis) comme montré figure 3a, sans pour autant noyer le treillis qui serait alors difficilement dissous. Lors du retrait du treillis, restent sur la face arrière des puces 10, outre les points de colle 30, de la résine 50 résiduelle que l'on peut voir figure 3b. Colle 30 et résine 50 sont retirées par exemple par polissage puis attaque chimique de la plaque 1 du côté face arrière des puces : le résultat est montré figure 3c.

Selon une autre variante décrite en relation avec les figures 4, le treillis comporte une première partie 42 formant un treillis et des piliers 43 formant une deuxième partie, qui traversent cette première partie et sont destinés à éloigner légèrement (d'une distance b) la première partie 42 du plan des puces de façon à pouvoir déposer une couche de résine 50 ayant une plus grande épaisseur que celle des puces 10 sans toutefois que la première partie 42 du treillis soit noyée dans cette couche de résine. L'épaisseur est mesurée dans la dimension perpendiculaire au plan de la plaque. Ces piliers 43 dont un exemple est donné figure 4a sont collés aux puces 10 à leur base. La couche de résine 50 remplit ainsi les espaces inter puces et recouvre les faces arrière 13 des puces en dehors des piliers. Ces piliers ont une épaisseur b typiquement comprise entre 100 µm et 1000 µm ; on peut ainsi recouvrir les faces arrière des puces avec une couche de résine par exemple de 50 µm à 300 µm d'épaisseur. Les piliers 43 ont par exemple à leur base, un diamètre de 2000 µm, pour une face arrière de la puce mesurant environ 4000 µm x 4000 µm.

On peut envisager différentes formes de piliers. Sur la figure 4e, le diamètre de la partie « haute » 43a du pilier fixée dans la première partie 42 du treillis est inférieur à celui de la base 43b des piliers qui sera collée sur les faces arrière des puces. Cette approche a l'avantage de rigidifier la première partie 42 du treillis qui comprend ainsi plus de matière.

Ces piliers 43 peuvent être dans le même matériau que la première partie 42 du treillis comme dans l'exemple de la figure 4a et réalisés en même temps par photogravure sélective par exemple. Après polymérisation de la résine, la première partie du treillis et les piliers sont retirés par exemple par attaque chimique.

Le treillis peut aussi être réalisé en deux matériaux différents, l'un pour les piliers 43, l'autre pour la première partie 42 comme représenté figures 4e et 4d. Celui des piliers est de préférence un matériau soluble tel que le cuivre ou l'aluminium, se dissolvant rapidement dans une solution de gravure chimique, si ces piliers sont destinés à disparaître ; ceci est le cas lorsque l'on ne souhaite pas augmenter l'épaisseur finale de la plaque 1. Dans la pratique la base du pilier qui est prise par la colle 30 polymérisée ne disparaît pas totalement lors de la dissolution du pilier comme montré figure 4b. Un polissage permet d'aplanir les surfaces irrégulières des différentes couches en surplus que l'on peut voir figure 4b, voire de réduire leur épaisseur comme visible figure 4c.

De plus le matériau des piliers n'a pas nécessairement un coefficient de dilatation faible ; en effet, c'est la première partie du treillis qui commande la dilatation. Ces piliers peuvent être des rivets de cuivre ou d'aluminium ou autre, rivetés à la première partie du treillis ; ils peuvent aussi être obtenus par croissance électrochimique localisée de cuivre, d'aluminium, ou autre, sur la première partie du treillis.

Le matériau de la première partie 42 du treillis est un matériau à faible coefficient de dilatation proche de celui du silicium, et est avantageusement non attaquable chimiquement dans la solution d'attaque chimique des piliers. On peut citer à titre d'exemple, le ferro-nickel, le Kovar, l'Invar ou la céramique (verre, alumine, nitrure d'aluminium par exemple). Cette partie du treillis (ou reste du treillis) est ainsi réutilisable ; on peut la protéger par un revêtement anti-adhérent de type téflon de façon à la rendre non adhérente au matériau du type résine époxy.

Dans les deux cas qui viennent d'être décrits, les piliers 43 sont retirés. Dans certains cas il est intéressant de ne pas les retirer : ils contribuent en effet à résoudre le problème thermique d'échauffement des puces en cours de fonctionnement, qui peut être important par exemple dès que des puces sont empilées. Ce problème thermique existe aussi dans le domaine de la téléphonie mobile où il faut éviter les points chauds, même si ces composants sont de faible puissance. Les piliers 43 qui sont laissés sur les puces 10 jouent alors un rôle de conducteurs de chaleur ; ils ont aussi un rôle d'uniformisation de la chaleur au niveau des puces et évitent ainsi des points chauds qui nuisent grandement à leur fiabilité.

Il n'est alors pas nécessaire que le matériau des piliers soit soluble dans une solution de gravure chimique ; il suffit qu'il soit bon conducteur de chaleur. L'aluminium remplit la première fonction mais moins bien la seconde mais le cuivre remplit ces deux fonctions ; en effet le cuivre qui a une résistance thermique de 360 W/m°K comparée à celle de l'époxy qui est de 0,6 W/m°K, est un conducteur thermique très puissant.

La forme de ces éléments caloporteurs 45 dont les piliers 43 sont un exemple et dont un autre exemple est montré figures 5, peut être adaptée pour remplir au mieux ces rôles de conduction et d'uniformisation de la chaleur. Le motif du treillis est déterminé par la forme des faces des puces 10, généralement rectangulaire, et par la disposition des puces sur le support, selon un quadrillage généralement rectangulaire. Pour s'adapter à un quadrillage rectangulaire de puces à faces rectangulaires, le treillis comporte par exemple des mailles rectangulaires délimitées par des barreaux 46 qui seront disposés à l'aplomb des espaces inter-puces après le collage du treillis sur les puces. Les éléments 45 du treillis destinés à devenir des éléments caloporteurs, sont également rectangulaires avec des dimensions légèrement inférieures à celles des faces des puces comme montré figure 5b ; ils sont situés dans les mailles de façon à être sur les faces arrière des puces après collage du treillis. Ces éléments 45 sont retenus au maillage (en l'occurrence aux barreaux 46) par des bretelles 47 ou pattes, quatre de préférence, passant à l'aplomb des coins des puces de façon à ne pas gêner le routage ultérieur de la puce lors par exemple d'un empilement de puces. Comme on le verra plus loin ces bretelles 47 ont également une fonction de conduction de chaleur. D'autres formes de treillis peuvent être envisagées pour s'adapter à d'autres formes de puces et de disposition des puces sur leur support.

L'épaisseur des éléments caloporteurs est typiquement comprise entre 50 et 200 µm. L'ensemble du treillis a la même épaisseur ; selon une variante l'épaisseur des bretelles 47 et des barreaux 46 est supérieure à celle des éléments caloporteurs 45 de manière à renforcer mécaniquement la rigidité du treillis. Un treillis à double épaisseur est par exemple obtenu par double gravure.

Lorsque lors du dépôt de la résine entre les puces (figures 5c et 5d), celle-ci déborde et recouvre partiellement les éléments caloporteurs 45 en surface, un polissage global de la plaque 1 est réalisé pour enlever ce surplus de résine.

La figure 5e montre la plaque 1 reconstituée après une étape de sciage collectif qui a pour fonction de :
- isoler les puces 10 les unes des autres,
- supprimer les barreaux 46 du treillis, la largeur « I » des sillons 81 de sciage étant supérieure à celle des barreaux ; elle est typiquement comprise entre 100 et 200 µm.

Un procédé de fabrication collective de modules électroniques 3D qui comprend un empilement de puces, comporte une étape d'empilement de plusieurs plaques reconstituées, puis une étape de sciage de l'ensemble des plaques empilées. On montre figure 6 un exemple de module 3D 2 qui comporte un empilement de deux étages de puces 10 et dont l'interconnexion électrique verticale est assurée par métallisation 60 des faces latérales de l'empilement selon un schéma électrique pré-établi permettant de connecter les différentes couches RDL 15 entre elles. Ces couches RDL 15 sont sur un support adhésif rigide 20'. Les éléments caloporteurs 45 sont intégrés dans l'empilement. Les bretelles (non visibles sur cette figure) qui débouchent sur les quatre coins du module à chaque étage, sont thermiquement connectées avec celles du dessus et/ou du dessous par des métallisations latérales du module 3D (distinctes des métallisations latérales d'interconnexion électrique) ce qui améliore le contact thermique des éléments caloporteurs vers l'extérieur. Dans le cas où plus de chaleur devrait être évacuée vers l'extérieur, il est possible de réserver une face latérale du module 3D à cette fonction en ajustant les dimensions des éléments caloporteurs 45 de manière à ce qu'un de leur côté affleure sur cette face latérale à chaque étage, puis en métallisant toute la face de manière à connecter thermiquement les côtés de ces éléments entre eux. Cette face du module 3D ne sera donc pas utilisée pour assurer une fonction d'interconnexion électrique verticale.

Selon un deuxième mode de réalisation de l'invention décrit en relation avec les figures 7, un treillis 40 est collé aux faces avant 12 des puces comme représenté figure 7a ; il s'agit d'un treillis métallique. Ceci est par exemple obtenu selon les étapes suivantes.
- Un film 70 de colle polymère suffisamment rigide pour ne pas tomber pas entre les mailles du treillis est déposé sur le treillis métallique 40 préalablement réalisé. Il s'agit typiquement d'un film de colle en époxy ou d'un film adhésif en polymère polymérisable.
- Les puces 10 sont reportées sur le film de colle 70 et collées par polymérisation de la colle (de préférence à température ambiante, par UV ou micro-ondes plutôt qu'à une température élevée), de façon à maintenir rigidement la position de chacune des puces sur le treillis avant le moulage de la résine. La température de transition de la colle polymère 70 doit être supérieure à la température de polymérisation de la résine de moulage 50 de manière à ne pas perdre ses propriétés de maintien en position de chaque puce durant la polymérisation de la résine de moulage. Dans ce mode de réalisation, le treillis 40 joue aussi le rôle de support des puces comme le support 22 des exemples précédents ; il a par exemple la forme du treillis décrit en relation avec les figures 2b, 2c et 2d. Le film de colle 70 a une double fonction de support adhésif 21 et de colle polymère 30 entre les puces et le treillis des exemples précédents.
- La résine 50 est alors déposée et polymérisée pour mouler les puces et former un substrat rigide et manipulable.
- Le treillis métallique 40 est alors retiré par exemple par dissolution comme on l'a déjà vu pour les exemples précédents.
- Le film de colle 70 est alors retiré intégralement ou partiellement seulement pour dégager les plots de connexion 11, par dissolution chimique ou par abrasion par laser ou par photogravure ou par plasma.
- De manière connue de l'homme du métier, la couche RDL qui peut comporter plusieurs couches de connexion, est alors formée pour relier les plots de connexion des puces vers la périphérie des puces.

Selon une variante représentée figures 7a et 7b, la forme du treillis est telle qu'aucune partie n'est à l'aplomb de ces plots. Dans ce cas, le treillis n'est pas intégralement retiré : comme présenté précédemment, des parties du treillis 45 et 47 sont avantageusement utilisées comme éléments caloporteurs pour évacuer la chaleur. Les barreaux 46 seront retirés ultérieurement lors du sciage de la plaque comme on l'a déjà vu ; une ligne de découpe est montrée figure 7e. Le treillis a une forme telle que celles décrites en relation avec les variantes à éléments caloporteurs comme par exemple une forme à bretelles 47 avec cependant une contrainte complémentaire : les dimensions des éléments caloporteurs 45 ne doivent pas être seulement inférieures à celles des faces avant 13 mais doivent aussi être inférieures à celles de la surface de la face active 12 délimitée par les plots de connexion 11 de la puce, comme on le voit figure 7b. De cette façon, la forme du treillis est telle qu'aucune partie n'est à l'aplomb de ces plots de connexion.

Jusqu'à présent le treillis était réalisé au préalable c'est-à-dire avant d'être collé aux puces.

Selon une variante du deuxième mode de réalisation, on a par exemple les étapes suivantes.
- Un film de colle polymère est déposé sur une plaque de maintien métallique, pleine.
- Les puces sont reportées sur le film de colle et collées par polymérisation de la colle (de préférence à température ambiante, par UV ou micro-ondes plutôt qu'à une température élevée), de façon à maintenir rigidement la position de chacune des puces sur la plaque de maintien avant le moulage de la résine.
- La résine est alors déposée et polymérisée pour mouler les puces et former un substrat rigide et manipulable.
- La plaque de maintien est alors retirée par exemple par dissolution comme on l'a déjà vu pour les exemples précédents.
- Le film de colle est alors retiré intégralement ou partiellement seulement pour dégager les plots de connexion, par dissolution chimique ou par abrasion par laser ou par photogravure ou par plasma.
- De manière connue de l'homme du métier, la couche RDL qui peut comporter plusieurs couches de connexion, est alors formée pour relier les plots de connexion des puces vers la périphérie des puces.

On a alors réalisé une plaque reconstituée.

Si cependant on souhaite conserver des éléments caloporteurs sur les faces avant des puces, cette partie de la plaque de maintien (correspondant aux éléments caloporteurs) est conservée mais il faut retirer au moins la partie de la plaque de maintien qui est à l'aplomb des plots ; cette partie-là est retirée par photogravure. Cela revient en quelque sorte à réaliser un treillis in situ.

Le retrait du film de colle 70 est alors un retrait partiel pour dégager les plots 11 de connexion des puces en vue de leur connexion à la couche de RDL comme indiqué précédemment.

L'étape de construction de la couche RDL est alors effectuée par dépôt d'une couche de diélectrique 15a par exemple par photogravure, puis par dépôt de pistes 15b de TiPd/Au ou TiW/Cu, comme illustré figures 7d et 7e ; celle-ci est plus difficile que dans le cas précédent du fait qu'elle doit être construite sur une surface non plane.

## Revendications

1. Procédé de fabrication d'une plaque (1) reconstituée qui comporte des puces sélectionnées (10) présentant des plots de connexion (11) sur une face de la puce dite face avant (12), ce procédé comprenant les étapes suivantes de :
- positionnement des puces sélectionnées (10) sur un support adhésif (20), face avant sur le support,
- dépôt d'une résine (50) sur le support (20) pour encapsuler les puces,
- polymérisation de la résine (50),
**caractérisé en ce que** :
- avant l'étape de dépôt de la résine, il comprend une étape de collage sur les faces arrière (13) des puces d'une plaque de maintien (40) du positionnement des puces, cette plaque de maintien (40) sous forme de treillis comportant des parties disposées sur une face arrière (13) des puces,
- après l'étape de polymérisation, il comprend une étape de retrait total ou partiel de la plaque de maintien (40).

2. Procédé de fabrication d'une plaque (1) reconstituée selon la revendication précédente, **caractérisé en ce que** le collage du treillis sur les puces comprend une étape de dépôt de colle polymère (30) sur les faces arrière (13) des puces, une étape de positionnement du treillis de manière à positionner des éléments du treillis (40) sur la colle puis une étape de polymérisation de la colle.

3. Procédé de fabrication d'une plaque (1) reconstituée selon l'une des revendications précédentes, **caractérisé en ce que** le treillis (40) comprend deux parties, une première partie (42) formant un treillis, et des piliers (43) formant une deuxième partie, ces piliers traversant la première partie.

4. Procédé de fabrication d'une plaque (1) reconstituée selon la revendication précédente, **caractérisé en ce qu'**une partie des piliers (43) reste collée aux puces (10) après l'étape de retrait du treillis.

5. Procédé de fabrication d'une plaque (1) reconstituée selon l'une quelconque des revendications 3 ou 4, **caractérisé en ce que** la première partie (42) du treillis est en céramique.

6. Procédé de fabrication d'une plaque (1) reconstituée selon l'une quelconque des revendications 3 ou 4, **caractérisé en ce que** la première partie (42) du treillis est en verre ou alumine ou nitrure d'aluminium.

7. Procédé de fabrication d'une plaque (1) reconstituée selon l'une quelconque des revendications précédentes, **caractérisé en ce que** la colle (30) est polymérisée à une température inférieure à 100 °C et/ou aux ultra violets et/ou aux micro-ondes.

8. Procédé de fabrication d'une plaque (1) reconstituée selon l'une quelconque des revendications précédentes, **caractérisé en ce que** le matériau principal des puces (10) ayant un coefficient de dilatation d'environ 3 ppm/°C, le matériau de la plaque de maintien (40) a un coefficient de dilatation inférieur à 10 ppm/°C.

9. Procédé de fabrication d'une plaque (1) reconstituée selon l'une quelconque des revendications 1 à 4, **caractérisé en ce que** la plaque de maintien (40) est totalement ou partiellement métallique.

10. Procédé de fabrication d'une plaque (1) reconstituée selon la revendication précédente, **caractérisé en ce que** la partie métallique de la plaque de maintien (40) est en Cuivre ou en Nickel ou en Aluminium ou en alliage ferro-nickel ou en alliage de kovar ou d'invar.

11. Procédé de fabrication d'une plaque (1) reconstituée selon l'une quelconque des revendications précédentes, **caractérisé en ce que** la plaque de maintien (40) a une épaisseur comprise entre 100 et 500 µm, cette épaisseur étant considérée dans la dimension perpendiculaire au plan de la plaque reconstituée (1).

12. Procédé de fabrication d'une plaque (1) reconstituée selon l'une quelconque des revendications précédentes, **caractérisé en ce que** la plaque de maintien est un treillis (40) métallique photogravé ou estampé.

## Patentansprüche

1. Verfahren zur Herstellung eines rekonstituierten Wafers (1), der ausgewählte Chips (10) umfasst, die Anschlusspads (11) auf einer Fläche des Chips (12) aufweisen, Frontfläche genannt, wobei das Verfahren die folgenden Schritte beinhaltet:
- Positionieren von ausgewählten Chips (10) auf der Frontfläche eines klebenden Substrats (20),
- Absetzen eines Harzes (50) auf das Substrat (20) zum Verkapseln der Chips,
- Polymerisieren des Harzes (50),
**dadurch gekennzeichnet, dass**:
- es vor dem Schritt des Absetzens des Harzes einen Schritt des Klebens, auf die Rückseiten (13) der Chips, eines Stützwafers (40) zum Positionieren der Chips beinhaltet, wobei dieser Stützwafer (40) in Form von Gittern mit Teilen vorliegt, die auf einer Rückseite (13) der Chips angeordnet sind,
- es nach dem Polymerisierungsschritt einen Schritt des vollständigen oder teilweisen Entfernens des Stützwafers (40) beinhaltet.

2. Verfahren zur Herstellung eines rekonstituierten Wafers (1) nach dem vorherigen Anspruch, **dadurch gekennzeichnet, dass** das Kleben des Gitters auf die Chips einen Schritt des Absetzens von Polymerklebstoff (30) auf die Rückseiten (13) der Chips, einen Schritt des Positionierens des Gitters zum Positionieren der Elemente des Gitters (40) auf dem Klebstoff, dann einen Schritt des Polymerisierens des Klebstoffs beinhaltet.

3. Verfahren zur Herstellung eines rekonstituierten Wafers (1) nach einem der vorherigen Ansprüche, **dadurch gekennzeichnet, dass** das Gitter (40) zwei Teile umfasst, wobei ein erster Teil (42) ein Gitter bildet, und Säulen (43), die einen zweiten Teil bilden, wobei diese Säulen den ersten Teil durchqueren.

4. Verfahren zur Herstellung eines rekonstituierten Wafers (1) nach dem vorherigen Anspruch, **dadurch gekennzeichnet, dass** ein Teil der Säulen (43) nach dem Schritt des Entfernens des Gitters auf den Chips (10) kleben bleibt.

5. Verfahren zur Herstellung eines rekonstituierten Wafers (1) nach einem der Ansprüche 3 oder 4, **dadurch gekennzeichnet, dass** der erste Teil (42) des Gitters aus Keramik ist.

6. Verfahren zur Herstellung eines rekonstituierten Wafers (1) nach einem der Ansprüche 3 oder 4, **dadurch gekennzeichnet, dass** der erste Teil (42) des Gitters aus Glas oder Aluminium oder Aluminiumnitrid ist.

7. Verfahren zur Herstellung eines rekonstituierten Wafers (1) nach einem der vorherigen Ansprüche, **dadurch gekennzeichnet, dass** der Klebstoff (30) bei einer Temperatur von weniger als 100°C und/oder im ultravioletten und/oder im Mikrowellenbereich polymerisiert wird.

8. Verfahren zur Herstellung eines rekonstituierten Wafers (1) nach einem der vorherigen Ansprüche, **dadurch gekennzeichnet, dass**, da das Hauptmaterial der Chips (10) einen Ausdehnungskoeffizienten um 3 ppm/°C hat, das Material des Stützwafers (40) einen Ausdehnungskoeffizienten von weniger als 10 ppm/°C hat.

9. Verfahren zur Herstellung eines rekonstituierten Wafers (1) nach einem der Ansprüche 1 bis 4, **dadurch gekennzeichnet, dass** der Stützwafer (40) ganz oder teilweise metallisch ist.

10. Verfahren zur Herstellung eines rekonstituierten Wafers (1) nach dem vorherigen Anspruch, **dadurch gekennzeichnet, dass** der metallische Teil des Stützwafers (40) aus Kupfer oder Nickel oder Aluminium oder einer Ferronickellegierung oder einer Kovar- oder Invarlegierung ist.

11. Verfahren zur Herstellung eines rekonstituierten Wafers (1) nach einem der vorherigen Ansprüche, **dadurch gekennzeichnet, dass** der Stützwafer (40) eine Dicke zwischen 100 und 500 µm hat, wobei diese Dicke als die Dimension lotrecht zur Ebene des rekonstituierten Wafers (1) angesehen wird.

12. Verfahren zur Herstellung eines rekonstituierten Wafers (1) nach einem der vorherigen Ansprüche, **dadurch gekennzeichnet, dass** der Stützwafer ein metallisches fotograviertes oder ausgestanztes Gitter (40) ist.

## Claims

1. A method for manufacturing a reconstituted wafer (1) that comprises selected chips (10) having connection pads (11) on a face of the chip, called front face (12), said method comprising the following steps:
- positioning selected chips (10) on an adhesive support (20), with the front face on the support;
- depositing a resin (50) onto the support (20) in order to encapsulate the chips;
- curing the resin (50),
**characterised in that**:
- before the step of depositing resin, it comprises a step of adhering, on the rear faces (13) of the chips, a support wafer (40) for positioning the chips, said support wafer (40) being in the form of a grid comprising parts disposed on a rear face (13) of the chips;
- after the curing step, it comprises a step of fully or partially removing the support wafer (40).

2. The method for manufacturing a reconstituted wafer (1) as claimed in the preceding claim, **characterised in that** adhering the grid on the chips comprises a step of depositing polymer adhesive (30) onto the rear faces (13) of the chips, a step of positioning the grid so as to position elements of the grid (40) on the adhesive, then a step of curing the adhesive.

3. The method for manufacturing a reconstituted wafer (1) as claimed in any one of the preceding claims, **characterised in that** the grid (40) comprises two parts, a first part (42) forming a grid and pillars (43) forming a second part, said pillars passing through the first part.

4. The method for manufacturing a reconstituted wafer (1) as claimed in the preceding claim, **characterised in that** part of the pillars (43) remains adhered to the chips (10) after the step of removing the grid.

5. The method for manufacturing a reconstituted wafer (1) as claimed in any one of claims 3 or 4, **characterised in that** the first part (42) of the grid is made of ceramic.

6. The method for manufacturing a reconstituted wafer (1) as claimed in any one of claims 3 or 4, **characterised in that** the first part (42) of the grid is made of glass or alumina or aluminium nitride.

7. The method for manufacturing a reconstituted wafer (1) as claimed in any one of the preceding claims, **characterised in that** the adhesive (30) is cured at a temperature below 100°C and/or by ultraviolet and/or by microwaves.

8. The method for manufacturing a reconstituted wafer (1) as claimed in any one of the preceding claims, **characterised in that**, with the main material of the chips (10) having an expansion coefficient of approximately 3 ppm/°C, the material of the support wafer (40) has an expansion coefficient below 10 ppm/°C.

9. The method for manufacturing a reconstituted wafer (1) as claimed in any one of claims 1 to 4, **characterised in that** the support wafer (40) is fully or partially metallic.

10. The method for manufacturing a reconstituted wafer (1) as claimed in the preceding claim, **characterised in that** the metal part of the support wafer (40) is made of copper or nickel or aluminium or ferro-nickel alloy or kovar or invar alloy.

11. The method for manufacturing a reconstituted wafer (1) as claimed in any one of the preceding claims, **characterised in that** the support wafer (40) is between 100 and 500 µm thick, this thickness being considered in the dimension perpendicular to the plane of the reconstituted wafer (1).

12. The method for manufacturing a reconstituted wafer (1) as claimed in any one of the preceding claims, **characterised in that** the support wafer is a photoetched or stamped metal grid (40).
